# EUROPEAN PATENT APPLICATION

(11) **EP 1 126 319 A1**
(43) Date of publication of application: **22.08.2001**
(21) Application number: 00931696.9
(22) Date of filing: 05.06.2000
(51) Int. Cl.: G03F 7/004, G03F 7/023, G03F 7/40, H01L 21/027

(54) **PHOTOSENSITIVE RESIN COMPOSITION AND METHOD OF IMPROVING DRY ETCHING RESISTANCE OF PHOTOSENSITIVE RESIN COMPOSITION**

(30) Priority: 08.06.1999 JP 16076399
(71) Applicant: CLARIANT INTERNATIONAL LTD., 4132 Muttenz (CH)
(72) Inventor: TAKAHASHI, Shuichi, Ogasa-gun Shizuoka 437-1496 (JP)
(74) Representative: Hütter, Klaus, Dr.
(86) International application number: JP0003635
(87) International publication number: WO0075728

(57) **Abstract**

A process capable of significantly improving dry-etching resistance of a radiation sensitive resin composition, which is capable of forming excellent patterns while maintaining high sensitivity and high resolution, and a radiation sensitive resin composition obtained thereby. The radiation sensitive resin composition comprises an alkali-soluble resin, a radiation sensitive material, and a fluorescent material in an amount of 0.0001 to 1.0 part relative to 100 parts by weight of the radiation sensitive material, wherein the weight average molecular weight of the alkali-soluble resin is at least 5 % higher than that of an alkali-soluble resin used in a radiation sensitive resin composition which in the absence of a sensitivity enhancer, exhibits the same sensitivity as the above-described radiation sensitive resin composition, resulting in improvement of dry-etching resistance. The fluorescent material has a high sensitivity improving effect so that it can improve sensitivity by addition thereof in a very small amount, thus permitting the sensitivity lowered due to use of a high molecular weight alkali-soluble resin to be improved without deterioration of the dry-etching resistance of the radiation sensitive resin composition.

## Description

### Technical Field

The present invention relates to a novel radiation sensitive resin composition and a process on the improvement of dry-etching resistance of a radiation sensitive resin composition, and in particular to a novel radiation sensitive resin composition having improved dry-etching resistance and a process on the improvement of dry-etching resistance for a radiation sensitive resin composition, which can be preferably used for production of semiconductors, formation of liquid crystal display faces for LCD panels, and production of circuit substrates such as thermal heads.

### Background Art

In a wide variety of fields including production of semiconductor integrated circuits such as LSI, formation of liquid crystal display faces for LCD panels, and production of circuit substrates such as thermal heads, photolithographic techniques have been used for formation of fine elements and fine processing. In the photolithographic techniques, positive- or negative-working radiation sensitive resin compositions have been used to form resist patterns. As the positive-working resin composition, a composition comprising an alkali-soluble resin and a quinone diazide compound is well-known as a radiation sensitive material. On this composition, there are described a variety of compositions as e.g. "novolak resin/quinone diazide compound" in many literatures such as Japanese Patent Application Publication (JP-B) No. 54-23570 (US Patent No. 3,666,473), JP-B No. 56-30850 (US Patent No. 4,115,128), Japanese Patent Application Laid-Open (JP-A) No. 55-73045 and JP-A No. 61-205933. Such a radiation sensitive resin composition is applied by a known method such as spin coating method, roller coating method, land coating method, cast coating method or dip coating method onto a silicon substrate, a substrate coated with a metal such as aluminum, molybdenum or chromium, or a substrate coated with a metal oxide film such as ITO, to form a thin film thereon, which is then exposed through a mask pattern for circuit etc. with radiation such as UV rays as a light source. After exposure, it is developed to form a resist pattern. Then fine processing of the substrate with dry-etching can be conducted by use of the resist pattern as an etching mask. In the dry-etching process, adequate dry-etching resistance is required to the resist pattern functioning as a mask. On the other hand, the large-sizing of substrates of LCD panels for TFT is advancing. From the viewpoint of throughput (yield per unit time), the radiation sensitive resin composition with higher sensitivity is required for producing the LCD panels. There is a strong demand, therefore, for realizing the radiation sensitive resin having both improved dry-etching resistance and higher sensitivity.

In such demand, improvement of dry-etching resistance is conducted generally by using an alkali-soluble resin having a higher molecular weight or by removing components having low-molecular weights in a specific range, such as monomer and dimer components, from an alkali-soluble resin (e.g., JP-A Nos. 60-97347 and 60-189739 and Japanese Patent No. 2590342). However, there arises another problem, that is, a deterioration in sensitivity in the former and a deterioration in both sensitivity and adhesion in the latter. To cope with this deterioration in sensitivity, it is necessary that a material called enhancer is added to attain higher sensitivity, or a low-molecular-weight component or an adhesion enhancer is added to improve adhesion. However, any materials used in these techniques are low-molecular-weight molecules and should be added in a large amount in order to satisfy the demand for sensitivity. Accordingly, dry-etching resistance once improved by using an alkali-soluble resin having a high average molecular weight is lowered by adding a large amount of such low-molecular-weight molecules. As a result, even if the alkali-soluble resin high-molecular-weighted is used, the dry-etching resistance of the composition is not significantly improved as compared with its initial radiation sensitive resin composition, that is, the alkali-soluble resin not high-molecular-weighted. Accordingly, it has been difficult to improve the dry-etching resistance of the radiation sensitive resin composition while maintaining its sensitivity.

In addition, a composition using a novolak resin containing β-naphthol as a condensation component (e.g., JP-A No. 60-173544) and a composition using a novolak resin containing terpenes as a component (e.g., JP-A No. 9-160234) are also proposed to improve etching resistance.

In methods proposed heretofore including above-described techniques, however, various properties such as etching resistance and sensitivity are not satisfied with good balance. A radiation sensitive resin composition satisfying such a demand, which has high sensitivity, high resolution and particularly excellent etching resistance, is strongly desired.

### Problems to be solved by the Invention

Under these circumstances, the object of the present invention is to provide a process capable of significantly improving dry-etching resistance, which is capable of forming excellent patterns while maintaining the high sensitivity and high resolution of the initial radiation sensitive resin composition, as well as a radiation sensitive resin composition excellent in balance of such characteristics.

### Means for solving the Problems

As a result of their eager study, the present inventors found that the object described above can be achieved by use of both an alkali-soluble resin having a specific weight average molecular weight and a sensitivity enhancer which, upon addition in a very small amount, is capable of realizing higher sensitivity, thus arriving at the present invention.

That is, the present invention relates to a radiation sensitive resin composition comprising an alkali-soluble resin, a radiation sensitive material, and a fluorescent material as a sensitivity enhancer, wherein as the alkali-soluble resin there is used an alkali-soluble resin having a weight average molecular weight which is at least 5 % higher than the weight average molecular weight of an alkali-soluble resin used in the initial radiation sensitive resin composition, that is, a radiation sensitive resin composition having the same constitution and the same sensitivity as the above-described radiation sensitive resin composition except that it does not contain the sensitivity enhancer and uses an alkali-soluble resin having a different weight average molecular weight.

Hereinafter, the present invention will be explained in more detail.

The reason why the radiation sensitive resin composition having significantly improved dry-etching resistance while maintaining the same sensitivity as in its initial radiation sensitive resin composition can be obtained in the present invention is considered as follows. First, the radiation sensitive resin composition of this invention makes use of an alkali-soluble resin having a weight average molecular weight which is at least 5 %, preferably 10 %, and more preferably 15 % higher than that of an alkali-soluble resin used in a radiation sensitive resin composition having the same constitution and the same sensitivity as the radiation sensitive resin composition of the present invention except that it does not contain the sensitivity enhancer and uses an alkali-soluble resin having a different weight average molecular weight. If the above-described high-molecular-weight alkali-soluble resin is used as the alkali-soluble resin but no sensitivity enhancer is used, the resulting radiation sensitive resin composition has improved dry-etching resistance as compared with the control alkali-soluble resin, but is not suitable for practical use because the sensitivity of the composition is significantly decreased owing to the high molecular weight of the alkali-soluble resin. On the other hand, as the sensitivity-improving effect of a conventional sensitivity enhancer is low, it should be used in a larger amount in order to satisfy the sensitivity required. As a result, the dry-etching resistance of the resulting radiation sensitive resin composition is lowered. In the present invention, the sensitivity of the radiation sensitive resin composition is made identical with that of the composition using the control alkali-soluble resin by addition of a sensitivity enhancer consisting of a fluorescent material having a very high effect of improving sensitivity. Because the fluorescent material used as sensitivity enhancer has a very high effect of improving sensitivity, it is sufficient to add the sensitivity enhancer in a very small amount so that the influence of the added sensitivity enhancer on characteristics except for sensitivity is so low as negligible. Accordingly, the radiation sensitive resin composition having the same sensitivity as in the control radiation sensitive resin composition can be obtained without a reduction in dry-etching resistance.

The alkali-soluble resin used in the present invention may have difference in weight average molecular weight from an alkali-soluble resin in the initial radiation sensitive resin composition, but have the same monomer component as that of the initial radiation sensitive resin composition. Accordingly, the alkali-soluble resin used in the present invention may be a resin whose weight average molecular weight has been raised to at least 5 % higher than that of the alkali-soluble resin in the initial radiation sensitive resin composition by fractionation of low-molecular components (e.g., monomer and dimer) in the alkali-soluble resin used in the initial radiation sensitive resin composition. It may also be a resin prepared separately from the same monomer as in an alkali-soluble resin in the initial radiation sensitive resin composition so as to have a weight average molecular weight which is at least 5 % higher than that of the alkali-soluble resin in the initial radiation sensitive resin composition.

The alkali-soluble resin in the radiation sensitive resin composition of the present invention may be any resin used as an alkali-soluble resin component in the conventional radiation sensitive resin compositions. Among these, a novolak phenol type resin obtained by polycondensation between at least one of phenols and aldehydes such as formalin is mentioned as a preferable example.

The phenols used preferably for producing this alkali-soluble novolak resin include e.g. cresols such as o-cresol, p-cresol and m-creosol; xylenols such as 3,5-xylenol, 2,5-xylenol, 2,3-xylenol and 3,4-xylenol; trimethylphenols such as 2, 3,4-trimethylphenol, 2,3,5-trimethylphenol, 2,4,5-trimethylphenol and 3,4,5-trimethylphenol; t-butylphenols such as 2-t-butylphenol, 3-t-butylphenol and 4-t-butylphenol; methoxyphenols such as 2-methoxyphenol, 3-methoxyphenol, 4-methoxyphenol, 2,3-dimethoxyphenol, 2,5-dimethoxyphenol, and 3,5-dimethoxyphenol; ethylphenols such as 2-ethylphenol, 3-ethylphenol, 4-ethylphenol, 2,3-diethylphenol, 3,5-diethylphenol, 2,3,5-triethylphenol and 3,4,5-triethylphenol; chlorophenols such as o-chlorophenol, m-chlorophenol, p-chlorophenol and 2,3-dichlorophenol; resorcinols such as resorcinol, 2-methylresorcinol, 4-methylresorcinol and 5-methylresorcinol; catechols such as 5-methylcatechol; pyrogallols such as 5-methylpyrogallol; bisphenols such as bisphenols A, B, C, D, E and F; methylol cresols such as 2,6-dimethylol-p-cresol; and naphthols such as α-naphthol and β-naphthol. These can be used alone or as a mixture thereof.

The aldehydes used preferably for producing the alkali-soluble novolak resin include salicylaldehyde, paraformaldehyde, acetaldehyde, benzaldehyde, hydroxy benzaldehyde and chloroacetaldehyde as well as formalin. These can be used alone or as a mixture thereof.

The alkali-soluble resin used in the present invention suffices for the need if it has enough resistance to arbitrary dry-etching conditions. It may also be a resin from which low-molecular-weight components have been removed as necessary by fractionation. The method of removing low-molecular-weight components from the novolak resin by fractionation includes e.g. liquid-liquid fractionation using 2 solvents having different dissolution abilities each other to the components, a method of removing low-molecular-weight components by centrifugation, and thin-film distillation.

The radiation sensitive material in the present invention is a material which can be chemically altered upon irradiation with a light of wavelength overlapping with the absorption zone of the radiation sensitive material, thus changing the solubility of the radiation sensitive resin composition in water or organic solvent. The radiation sensitive material, which can be used together with the alkali-soluble resin, includes e.g. a compound containing a quinone diazide group. This compound containing a quinone diazide group, which can be used in the present invention, may be an any known radiation sensitive material used conventionally in quinone diazide-novolak type resist.

The compound containing a quinone diazide group is preferably one obtained by allowing naphthoquinone diazide sulfonyl chloride such as 1,2-naphthoquinone-diazide-5-sulfonyl chloride and 1,2-naphthoquinone-diazide-4-sulfonyl chloride, or benzoquinone diazide sulfonyl chloride to react with a low-molecular or high-molecular compound having a functional group capable of condensation reaction with these acid chlorides. The functional group which can be condensed with an acid chloride includes a hydroxyl group, an amino group etc. Among these, a hydroxyl group is particularly preferable. The compound containing a hydroxyl group which can be condensed with an acid chloride includes e.g. hydroquinone; resorcinol; hydroxybenzophenones such as 2,4-dihydroxybenzophenone, 2,3,4-trihydroxybenzophenone, 2,4,6-trihydroxybenzophenone, 2,4,4'-trihydroxybenzophenone, 2,3,4,4'-tetrahydroxybenzophenone, 2,2',4,4'-tetrahydroxybenzophenone and 2,2',3,4,6'-pentahydroxybenzophenone; hydroxyphenylalkanes such as bis(2,4-dihydroxyphenyl)methane, bis(2,3,4-trihydroxyphenyl)methane and bis (2,4-dihydroxyphenyl)propane; and hydroxytriphenylmethanes such as 4,4',3",4"-tetrahydroxy-3,5,3',5'-tetramethyl triphenyl methane and 4,4',2",3",4"-pentahydroxy-3,5,3',5'-tetramethyl triphenyl methane. These can be used alone or in combination of two or more. The amount of the radiation sensitive material containing a quinone diazide group is usually 5 to 50 parts by weight, preferably 10 to 40 parts by weight relative to 100 parts by weight of the alkali-soluble resin. In the radiation sensitive resin composition according to the present invention, a radiation sensitive resin consisting of a reaction product between the alkali-soluble resin and the quinone diazide compound may also be used.

On the other hand, in the radiation sensitive resin composition of the present invention, a fluorescent material is used as sensitivity enhancer. Although the present invention is not bound by theory, the reason why higher sensitivity can be achieved in the present invention by use of a small amount of fluorescent material is considered as follows:

It is known that the photosensitive speed of a radiation sensitive material varies depending on the wavelength of irradiation light. For example, it is known that a radiation sensitive material with photosensitive speed decreased in order of g-line, h-line and i-line when irradiated with light of g-line, h-line and i-line. When such a radiation sensitive material is used, it is considered to convert the light energy of i-line into energy corresponding to g-line or h-line as a method of improving the sensitivity of a resist upon irradiation with i-line. For this energy transfer, the phenomenon of energy transfer can be utilized by selecting a suitable fluorescent material for the wavelength of a light source and the absorption wavelength of a radiation sensitive material. As one model on this phenomenon of energy transfer, an energy transfer model of Foerster type (Foerster, Th., Naturwiss, 33, pp. 166-171, 1946) can be mentioned. The characteristic feature of the energy transfer model of Foerster type is that although a fluorescent material is used, the transfer of excitation energy from a donor to an acceptor occurs without via fluorescence. If the transfer proceeds via fluorescence, the excitation energy of the excited fluorescent material is lost upon emission of fluorescence therefrom. In the energy transfer of Foerster type, however, the transfer of excitation energy from a donor to an acceptor proceeds without emission of fluorescence, that is any loss in excitation energy. As a model of using this phenomenon of the energy transfer of Foerster type, a photosynthetic antenna dye system in plant is mentioned. In this system, short wavelength in sunlight is transformed via several steps of wavelength transformation into energy of long wavelength that lies in a central absorption peak in photosynthetic reaction. The efficiency of transfer of excitation energy in this system is almost 100 %. In the long process of evolution, the transfer of excitation energy in the photosynthetic antenna dye system came to select the most efficient process where the transfer occurs without via fluorescence. As can be seen from this fact, the energy transfer of Foerster type without via fluorescence is highly efficient as compared with the transfer of excitation energy via fluorescence. Further, the most significant difference between the transfer of excitation energy proceeding via fluorescence and the transfer of excitation energy proceeding without via fluorescence is the concentration of a fluorescent material in the system. If excitation energy is transferred via fluorescence (e.g., JP-A No. 62-81634), a fluorescent material is added in an extraordinarily larger amount than in the present invention. In such a system, therefore, the transfer of excitation energy proceeding without via fluorescence, which occurs at a very low concentration as shown in the present invention, cannot be realized, and the excitation energy cannot be efficiently utilized.

The fluorescent material used as sensitivity enhancer in the present invention includes the following organic fluorescent materials: naphthalene and derivatives thereof such as 1-hydroxynaphthalene, 1-methylnaphthalene, 2,3-dimethylnaphthalene, 1-aminonaphthalene, 2-fluoronaphthalene, 2-chloronaphthalene and 1,7-diphenylnaphthalene; anthracene and derivatives thereof such as 9-methylanthracene, 9,10-dimethylanthracene, 9-cyanoanthracene, 1-aminoanthracene, 9-phenylanthracene, 9,10-diphenylanthracene, 9,10-dichloroanthracene, 9,10-dinaphthylanthracene, 9-vinylanthracene and 9-(p-vinylphenyl)-10-phenylanthracene; phenanthrene and derivatives thereof such as 3,4'-benzophenanthrene and 2-phenylphenanthrene; pyrene and derivatives thereof such as 1,3,6,8-tetraphenylpyrene, bipyrenyl and o-phenylenepyrene; perylene and derivatives thereof such as benzoperylene; fluorene and derivatives thereof such as 1-methylfluorene and 1,2-benzofluorene; carbazole and derivatives thereof such as N-methylcarbazole, N-methylbenzocarbazole, N-phenylcarbazole and N-vinylcarbazole; biphenyl and derivatives thereof such as 4-methylphenylbiphenyl, 3,3'-dimethylbiphenyl, 4-methoxybiphenyl, 4,4'-dimethoxybiphenyl, 4,4'-dihydroxybiphenyl, 4-benzylbiphenyl, 4-vinylbiphenyl and octamethylbiphenyl; p-terphenyl and derivatives thereof such as 4-methylterphenyl, 2-methyl-p-terphenyl, 3,3"-dimethylterphenyl, 4-(3,3-dimethylbutoxy)-p-terphenyl and 2,2'-methylene-p-terphenyl; p-quaterphenyl and derivatives thereof such as 3',3'''-dimethyl-p-quaterphenyl, tetramethyl-p-quaterphenyl and 4-(3-ethylbutoxy)-p-quaterphenyl; indole and derivatives thereof such as 2-phenylindole, 1-methyl-2-phenylindole, 1-N-butyl-2-biphenylindole, 1,2-diphenylindole and 1-biphenyl-2-indole; acridine and derivatives thereof, naphthacene and derivatives thereof, and rubrene and derivatives thereof; and chrysene and derivatives thereof. These are selected preferably in consideration of the wavelength of irradiation light used and the absorption wavelength range of the radiation sensitive material used in combination, and these may be used singly or in combination of 2 or more. The amount of the fluorescent material is 0.0001 to 1.0 part by weight, preferably 0.0005 to 0.5 part by weigh, relative to 100 parts by weight of the radiation sensitive material.

The solvent used for the radiation sensitive resin composition of the present invention includes ethylene glycol monoalkyl ethers such as ethylene glycol monomethyl ether and ethylene glycol monoethyl ether; ethylene glycol monoalkyl ether acetates such as ethylene glycol monomethyl ether acetate and ethylene glycol monoethyl ether acetate; propylene glycol monoalkyl ethers such as propylene glycol monomethyl ether and propylene glycol monoethyl ether; propylene glycol monoalkyl ether acetates such as propylene glycol monomethyl ether acetate and propylene glycol monoethyl ether acetate; lactates such as methyl lactate and ethyl lactate; aromatic hydrocarbons such as toluene and xylene; ketones such as methyl ethyl ketone, 2-heptanone and cyclohexanone; amides such as N,N-dimethylacetamide and N-methylpyrrolidone; and lactones such as γ-butyrolactone. These solvents can be used alone or in combination of 2 or more.

Dyestuffs, adhesive aids, surface active agents etc. may be incorporated as necessary into the radiation sensitive resin composition of the present invention. The dyestuffs include e.g. Methyl Violet, Crystal Violet, Malachite Green etc.; the adhesive aids include e.g. alkyl imidazoline, butyric acid, alkyl acid, polyhydroxystyrene, polyvinylmethyl ether, t-butyl novolak, epoxy silane, epoxy polymer, silane etc.; and the surface active agents include e.g. nonionic surface active agents such as polyglycols and derivatives thereof, that is, polypropylene glycol or polyoxyethylene lauryl ether, fluorine-containing surface active agents such as Fluorad™ (Sumitomo 3M Ltd.), Megafac™ (Dainippon Ink and Chemicals, Inc.), Sulflon™ (Asahi Glass Co., Ltd.) or organic siloxane surface active agents such as KP341 (Shin-Etu Chemical Co., Ltd.).

As described above, in the present invention the radiation sensitive resin composition comprises an alkali-soluble resin, a radiation sensitive material and a fluorescent material as a sensitivity enhancer, wherein the weight average molecular weight of the alkali-soluble resin is raised to at least 5 % higher than that of an alkali-soluble resin used in the initial radiation sensitive resin composition, whereby the dry-etching resistance of the radiation sensitive resin composition can be improved. The radiation sensitive resin composition of the present invention obtained by the method of improving dry-etching resistance can be preferably used for production of semiconductors, formation of liquid crystal display faces for LCD panels, and production of circuit substrates such as thermal heads.

### Best mode for practicing the Invention

The present invention will be now described in more detail by reference to Examples which, however, are not to be construed to limit the present invention in any way.

### Example 1

100 parts by weight of a novolak resin, from which monomers and dimers had been removed, with a weight average molecular weight of 6,800 as determined using polystyrene standards, 15 parts by weight of a mixture of esters between 2,3,4,4'-tetrahydroxybenzophenone and 1,2-naphthoquinonediazide-5-sulfonyl chloride and 1,2-naphthoquinonediazide-4-sulfonyl chloride as a radiation sensitive material and 0.0025 part by weight of 9,10-dichloroanthracene for fluorescent material, as a sensitivity enhancer, per 100 parts by weight of the radiation sensitive material were dissolved in propylene glycol monomethyl ether acetate. To the resulting solution the fluorine-based surface active agent Fluorad™ F-472 (Sumitomo 3M Ltd.) was added at 300 ppm to prevent the so-called striation i.e. radial wrinkles formed on a resist film upon spin coating. The solution was stirred and filtered through a 0.2 µm filter to prepare the radiation sensitive resin composition of the present invention. This composition was spin-coated on a 4-inch silicon wafer and baked at 100 °C for 90 seconds on a hot plate to give a resist film of 1.5 µm in thickness. This resist film was exposed through a test pattern having various line and space width patterns, which have 1:1 line and space width respectively, using an i-line stepper (LD-5015iCW manufactured by Hitachi Ltd.) and developed at 23 °C for 60 seconds with 2.20 weight % aqueous tetramethyl ammonium hydroxide solution. After development, the sensitivity of the pattern was assessed as an amount of exposure energy (E₀) providing a 1:1 resolution of 5 µm line-and-space. The results are shown in Table 1.

In addition, a radiation sensitive resin coating film of 1.5 µm in thickness was prepared in the same manner as described above, and then dry-etched for 5 minutes in a gas having a composition of C₂F₆ : CHF₃ : He = 16 : 24 : 100 and at 90, 100, 110, 120, 130 and 140 W respectively in an ion etching unit (RIE-10N) manufactured by Samuco Co., Ltd. After etching, the surface of the coating film was observed, and the results in Table 2 were obtained.

The evaluation of the surface conditions of the coating film after etching was conducted under the following criteria. A film above rank B can be practically used.
A: No change
B: Turned green
C: Cloudy
D: Carbonized

### Example 2

The same procedure as in Example 1 was conducted except that a novolak resin, from which monomers and dimers had been removed, having a weight average molecular weight of 7,100 as determined using polystyrene standards was used as novolak resin, and that 9,10-dichloroanthracene for fluorescent material was added in an amount of 0.005 part by weight per 100 parts by weight of the radiation sensitive material. The results shown in Tables 1 and 2 were obtained.

### Example 3

The same procedure as in Example 1 was conducted except that a novolak resin, from which monomers and dimers had been removed, having a weight average molecular weight of 7,400 as determined using polystyrene standards was used as novolak resin, and that 9,10-dichloroanthracene for fluorescent material was added in an amount of 0.0075 part by weight per 100 parts by weight of the radiation sensitive material. The results shown in Tables 1 and 2 were obtained.

### Comparative Example 1

The same procedure as in Example 1 was conducted except that no sensitivity enhancer was incorporated and the results shown in Tables 1 and 2 were obtained.

### Comparative Example 2

The same procedure as in Example 2 was conducted except that no sensitivity enhancer was incorporated and the results shown in Tables 1 and 2 were obtained.

### Comparative Example 3

The same procedure as in Example 3 was conducted except that no sensitivity enhancer was incorporated and the results shown in Tables 1 and 2 were obtained.

### Comparative Example 4

The same procedure as in Example 1 was conducted except that a novolak resin, from which monomers and dimers had been removed, having a weight average molecular weight of 6,400 as determined using polystyrene standards was used as novolak resin and no sensitivity enhancer was incorporated. The results shown in Tables 1 and 2 were obtained.

### Comparative Example 5

The same procedure as in Example 1 was conducted except that as sensitivity enhancer, o-cresol was used in place of the fluorescent material and added in an amount of 40 parts by weight per 100 parts by weight of the radiation sensitive material. The results shown in Tables 1 and 2 were obtained.

**Table 1**

| | Weight average molecular weight of novolak resin | Amount of fluorescent material added (parts by weight per 100 parts by weight of the radiation sensitive material) | Sensitivity Eo(mJ/cm²) |
|---|---|---|---|
| Example 1 | 6800 | 0.0025 | 102 |
| Example 2 | 7100 | 0.0050 | 101 |
| Example 3 | 7400 | 0.0075 | 103 |
| Comparative Example 1 | 6800 | 0 | 112 |
| Comparative Example 2 | 7100 | 0 | 121 |
| Comparative Example 3 | 7400 | 0 | 132 |
| Comparative Example 4 | 6400 | 0 | 102 |
| Comparative Example 5 | 6800 | 40 parts by weight of o-cresol | 102 |

**Table 2**

| Etching condition | | Surface conditions of the resist coating film | | | | | | | |
|---|---|---|---|---|---|---|---|---|---|
| W | Time (min.) | Example 1 | Example 2 | Example 3 | Comparative Example 1 | Comparative Example 2 | Comparative Example 3 | Comparative Example 4 | Comparative Example 5 |
| 90 | 5 | A | A | A | A | A | A | B | B |
| 100 | 5 | A | A | A | B | A | A | C | C |
| 110 | 5 | A | A | A | C | B | A | C | C |
| 120 | 5 | B | A | A | D | C | B | D | D |
| 130 | 5 | C | B | A | D | C | C | D | D |
| 140 | 5 | C | C | B | D | D | C | D | D |

As is evident from comparison among the average molecular weights and sensitivities in Table 1 and from the results of etching resistance in Table 2, particularly from the results at 110 W and 120 W as practical etching conditions, higher sensitivity can be achieved without deterioration of etching resistance according to the present invention where the alkali-soluble resin having at least 5 % higher weight average molecular weight than that of an alkali-soluble resin used in the initial radiation sensitive resin composition is used along with the fluorescent material which can improve the sensitivity upon addition in a very small amount.

### Effect of the Invention

According to the present invention, the radiation sensitive resin composition capable of not only forming excellent patterns but also significantly improving dry-etching resistance while maintaining high sensitivity and high resolution can be obtained. Accordingly, the radiation sensitive resin composition obtained in the present invention is of significant usefulness and can be preferably used for production of semiconductor devices and liquid crystal displays.

## Claims

1. A radiation sensitive resin composition comprising an alkali-soluble resin, a radiation sensitive material, and a fluorescent material as a sensitivity enhancer, wherein said alkali-soluble resin has a weight average molecular weight which is at least 5 % higher than the weight average molecular weight of an alkali-soluble resin used in a radiation sensitive resin composition having the same constitution and the same sensitivity as the above-described radiation sensitive resin composition except that it does not contain the sensitivity enhancer and uses an alkali-soluble resin having a different weight average molecular weight.

2. The radiation sensitive resin composition according to claim 1, wherein the amount of the fluorescent material added is 0.0001 to 1.0 part by weight relative to 100 parts by weight of the radiation sensitive material.

3. A process on the improvement of dry-etching resistance for a radiation sensitive resin composition comprising an alkali-soluble resin, a radiation sensitive material, and a fluorescent material as a sensitivity enhancer, wherein the alkali-soluble resin has a weight average molecular weight which is at least 5 % higher than the weight average molecular weight of an alkali-soluble resin used in a radiation sensitive resin composition having the same composition and the same sensitivity as the above-described radiation sensitive resin composition except that it does not contain the sensitivity enhancer and uses an alkali-soluble resin having a different weight average molecular weight.

4. The process on the improvement of dry-etching resistance for a radiation sensitive resin composition according to claim 3, wherein the amount of said fluorescent material added is 0.0001 to 1.0 part by weight relative to 100 parts by weight of the radiation sensitive material.
